# EUROPEAN PATENT SPECIFICATION

(11) **EP 4 272 033 B1**
(45) Date of publication and mention of the grant of the patent: **27.05.2026**
(21) Application number: 21841019.9
(22) Date of filing: 28.12.2021
(51) Int. Cl.: G03F 7/00

(54) **METHOD FOR STRUCTURED REPLICATION AND TRANSFER**
VERFAHREN FÜR STRUKTURIERTE REPLIKATION UND ÜBERTRAGUNG
PROCÉDÉ DE REPRODUCTION ET DE TRANSFERT STRUCTURÉS

(30) Priority: 31.12.2020 US 202063199477 P
(43) Date of publication of application: 08.11.2023
(73) Proprietor: 3M Innovative Properties Company, Saint Paul, Minnesota 55133-3427 (US)
(72) Inventor: SONNIER, Ashley R., Saint Paul, Minnesota 55133-3427 (US); ZHU, James, Saint Paul, Minnesota 55133-3427 (US); HUNT, Lucas J., Saint Paul, Minnesota 55133-3427 (US); KUSILEK, Edwin L., Saint Paul, Minnesota 55133-3427 (US); ARMSTRONG, Paul B., Saint Paul, Minnesota 55133-3427 (US)
(74) Representative: Mathys & Squire
(86) International application number: PCT/IB2021/062391
(87) International publication number: WO 2022/144773

(56) References cited:
- JP-A- H11 204 551
- JP-A- H11 204 551
- US-A1- 2008 011 934
- US-A1- 2008 011 934
- US-A1- 2018 100 046
- US-A1- 2018 100 046
- US-A1- 2019 134 593
- US-A1- 2019 134 593
- US-A1- 2019 391 483
- US-A1- 2019 391 483
- CANNISTRA A T ET AL: "Fabrication of guided mode resonance filters on conformal surfaces", ADVANCED FABRICATION TECHNOLOGIES FOR MICRO/NANO OPTICS AND PHOTONICS IV, SPIE, 1000 20TH ST. BELLINGHAM WA 98225-6705 USA, vol. 7927, no. 1, 10 February 2011 (2011-02-10), pages 1 - 8, XP060020622, DOI: 10.1117/12.876280
- J.-H. LEE ET AL: "Two-Polymer Microtransfer Molding for Highly Layered Microstructures", ADVANCED MATERIALS, vol. 17, no. 20, 17 October 2005 (2005-10-17), pages 2481 - 2485, XP055006882, ISSN: 0935-9648, DOI: 10.1002/adma.200500721
- CANNISTRA A T ET AL: "Fabrication of guided mode resonance filters on conformal surfaces", ADVANCED FABRICATION TECHNOLOGIES FOR MICRO/NANO OPTICS AND PHOTONICS IV, SPIE, 1000 20TH ST. BELLINGHAM WA 98225-6705 USA, vol. 7927, no. 1, 10 February 2011 (2011-02-10), pages 1 - 8, XP060020622, DOI: 10.1117/12.876280
- J.-H. LEE ET AL: "Two-Polymer Microtransfer Molding for Highly Layered Microstructures", ADVANCED MATERIALS, vol. 17, no. 20, 17 October 2005 (2005-10-17), pages 2481 - 2485, XP055006882, ISSN: 0935-9648, DOI: 10.1002/adma.200500721

## Description

### BACKGROUND

Imprint lithography techniques have been widely investigated as alternatives to conventional photolithography for high-resolution patterning. Imprint lithography techniques generally use a template containing topography to replicate a surface relief on a substrate.

US2008011934 A1 discloses a method of making an imprint lithography template, the method comprising applying a curable material to a patterned surface of a master imprint template; curing the curable material and thereby forming a second imprint template having a patterned surface which is the inverse of the patterned surface of the master imprint template; removing the second imprint template from the master imprint template; applying inorganic sol-gel to a substrate; imprinting the inorganic sol-gel with the second imprint template; allowing the inorganic sol-gel to cure; and removing the second imprint template from the cured inorganic sol-gel, such that the inorganic sol-gel forms a third imprint template having a patterned surface which corresponds with the patterned surface of the master imprint template

### SUMMARY

Briefly, in one aspect, the present disclosure describes a method of making a patterned surface structure on a substrate. The method includes providing one or more patterned templates each including a relief structure; coating the relief structure of each patterned template with a replication medium in the form of a liquid; solidifying the replication medium to replicate a pattern of the relief structure on a first side of the replication medium and form a substantially planar surface on a second side thereof opposite the first side; transferring the one or more patterned templates with the respective replication media to an array of sub-regions of a tiling region on a major surface of a substrate, the substantially planar surface of each replication medium being in contact to the respective sub-regions of the substrate; and removing the one or more patterned templates from the substrate to form a patterned surface structure on the substrate; wherein the one or more patterned templates comprises first and second patterned templates, and transferring the one or more patterned templates further comprises transferring the first and second templates either (i) sequentially onto a first sub-region and a second sub-region of the tiling region on the major surface of the substrate, respectively, or (ii) at the same time onto a first sub-region and a second sub-region of the tiling region on the major surface of the substrate, respectively.

Various unexpected results and advantages are obtained in exemplary embodiments of the disclosure. One such advantage of exemplary embodiments of the present disclosure is that a substantially solid replication medium at room temperature can be formed from a liquid form on a patterned template, which eases handling and storage during intermediate processing steps such as, for example, while coating or transferring replication medium on other patterned templates for other sub-regions on the same substrate.

Various aspects and advantages of exemplary embodiments of the disclosure have been summarized. The above Summary is not intended to describe each illustrated embodiment or every implementation of the present certain exemplary embodiments of the present disclosure. The Drawings and the Detailed Description that follow more particularly exemplify certain preferred embodiments using the principles disclosed herein.

### BRIEF DESCRIPTION OF THE DRAWINGS

The disclosure may be more completely understood in consideration of the following detailed description of various embodiments of the disclosure in connection with the accompanying figures, in which:
FIG. 1 is a schematic diagram of a process for forming an array of patterns on a substrate, according to one embodiment.
FIG. 2 is a cross-sectional schematic diagram of the process of FIG. 1.
FIG. 3 is a cross-sectional schematic diagram of a process of replicating a pattern of a patterned template on a replication medium, according to one embodiment.
FIG. 4A is a schematic diagram of a serial process for forming an array of patterns on a substrate, according to one embodiment.
FIG. 4B is a schematic diagram of a simultaneous process for an array of patterns on a substrate, according to another embodiment.

In the drawings, like reference numerals indicate like elements. While the above-identified drawing, which may not be drawn to scale, sets forth various embodiments of the present disclosure, other embodiments are also contemplated, as noted in the Detailed Description. In all cases, this disclosure describes the presently disclosed disclosure by way of representation of exemplary embodiments and not by express limitations. It should be understood that numerous other modifications and embodiments can be devised by those skilled in the art, which fall within the scope of this disclosure.

### DETAILED DESCRIPTION

For the following Glossary of defined terms, these definitions shall be applied for the entire application, unless a different definition is provided in the claims or elsewhere in the specification.

### Glossary

Certain terms are used throughout the description and the claims that, while for the most part are well known, may require some explanation. It should be understood that:
The terms "(co)polymer" or "(co)polymers" includes homopolymers and copolymers, as well as homopolymers or copolymers that may be formed in a miscible blend, *e.g.,* by coextrusion or by reaction, including, e.g., transesterification. The term "copolymer" includes random, block and star (e.g. dendritic) copolymers.

The term "protectant resin" refers to a film or a film forming composition of monomer, polymer, solvent, and/or other additives composed so as to substantially protect a surface from damage or contamination when disposed on the surface.

The term "protective tile" refers to a film of protectant resin, substantially solid, disposed on a surface such that at least a portion of the surface is covered by said film of protectant resin and thereby protected from damage or contamination.

The term "imprint lithography" refers to a method of replicating a pre-defined relief structure of a patterned template by imprinting or embossing the patterned template into a replication medium. The imprinting or embossing step includes mechanical deformation of a replication medium that results in replication of the relief structure. A pattern transfer process can optionally be used to transfer the pattern of the replication medium into the underlying substrate by, e.g., wet etching, reactive ion etching, etc. Embodiments of this disclosure is different from conventional imprint lithography processes in that, for example, embodiments of this disclosure provide methods which do not include imprinting or embossing steps for mechanical deformation of a replication medium.

The term "structured transfer film" refers to an article including a patterned template having a relief structure and a backfill layer applied to the relief structure, where the structured transfer film is configured and arranged for transfer of at least a portion of the backfill layer to a substrate while substantially preserving the backfill layer relief structures of that portion. Embodiments of this disclosure are different from conventional structured transfer film processes in that, for example, i) embodiments of this disclosure provide methods for tiling one or more structured transfer films; ii) embodiments of this disclosure provide a replication medium that is applied as a liquid and then solidified to form a structured transfer film article that is solid at room temperature, and thereby easier to handle and/or transport; iii) embodiments of this disclosure provide a replication medium including a curable polymeric resin which is solid at room temperature and can be hardened or toughened through curing before removing the one or more patterned templates; and iv) embodiments of this disclosure provide a tiled patterned surface structure that can be used to generate a tool for further replication processing such as electroplating, polymer replication, etching, etc.

The terms "about" or "approximately" with reference to a numerical value or a shape means +/- five percent of the numerical value or property or characteristic, but expressly includes the exact numerical value. For example, a viscosity of "about" 1 Pa-sec refers to a viscosity from 0.95 to 1.05 Pa-sec, but also expressly includes a viscosity of exactly 1 Pa-sec. Similarly, a perimeter that is "substantially square" is intended to describe a geometric shape having four lateral edges in which each lateral edge has a length which is from 95% to 105% of the length of any other lateral edge, but which also includes a geometric shape in which each lateral edge has exactly the same length.

The term "substantially" with reference to a property or characteristic means that the property or characteristic is exhibited to a greater extent than the opposite of that property or characteristic is exhibited. For example, a substrate that is "substantially" transparent refers to a substrate that transmits more radiation (e.g. visible light) than it fails to transmit (e.g. absorbs and reflects). Thus, a substrate that transmits more than 50% of the visible light incident upon its surface is substantially transparent, but a substrate that transmits 50% or less of the visible light incident upon its surface is not substantially transparent.

As used in this specification and the appended embodiments, the singular forms "a", "an", and "the" include plural referents unless the content clearly dictates otherwise. Thus, for example, reference to fine fibers containing "a compound" includes a mixture of two or more compounds. As used in this specification and the appended embodiments, the term "or" is generally employed in its sense including "and/or" unless the content clearly dictates otherwise.

As used in this specification, the recitation of numerical ranges by endpoints includes all numbers subsumed within that range (e.g. 1 to 5 includes 1, 1.5, 2, 2.75, 3, 3.8, 4, and 5).

Exemplary embodiments of the present disclosure may take on various modifications and alterations without departing from the scope of the present disclosure. Accordingly, it is to be understood that the embodiments of the present disclosure are not to be limited to the following described exemplary embodiments, but is to be controlled by the limitations set forth in the claims. Various exemplary embodiments of the disclosure will now be described with particular reference to the Drawings.

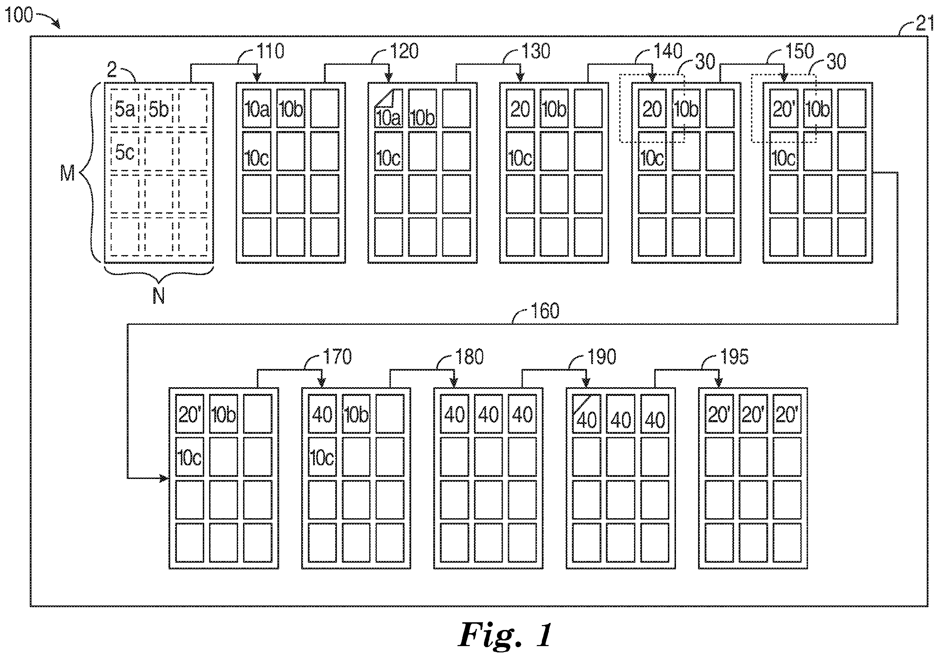

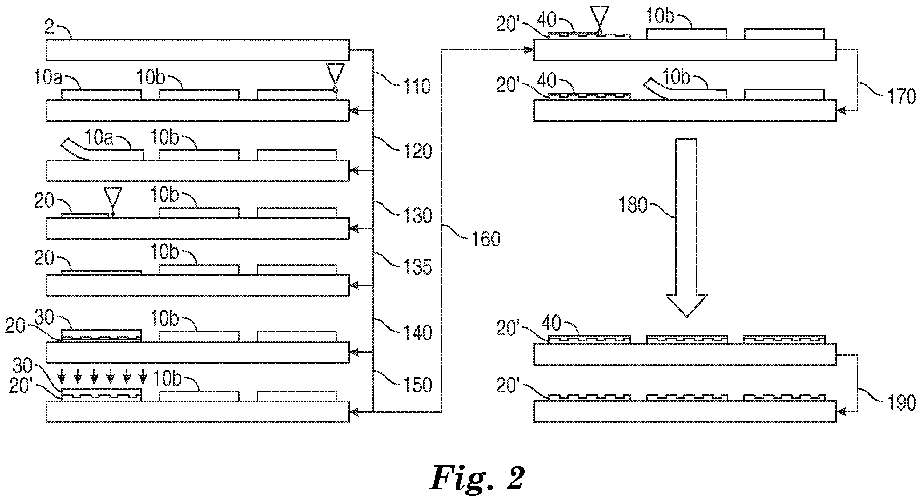

FIG. 1 is a schematic diagram of a process 100 for forming an array of patterns on a substrate, according to one embodiment. FIG. 2 is a cross-sectional view of the process of FIG. 1 with minor variances. The substrate 2 may include flexible polymeric substrates, glass, quartz, silicon wafers, polished metal, rigid polymer substrates, etc. A tiling region is provided on the first major surface 21 of the substrate 2. The tiling region includes an array of sub-regions 5a, 5b, 5c, etc. (e.g., an M x N matrix, where M=1, 2, 3, etc., and N=1, 2, 3, etc.). The sub-regions may have an average area, for example, in a range from 1 mm² to 2000000 mm². A gap between the adjacent sub-regions may be in a range, for example, from about 0 mm to 100 mm. The array of sub-regions may include, for example, from 2 to 10000 sub-regions regularly or irregularly arranged on the first major surface of the substrate. Typically, sub-regions of a substrate can be pre-cleaned in an ultrasonic water-detergent bath and subsequently O₂ plasma treated to remove residual detergent.

At 110, protective tiles (10a, 10b, 10c, etc.) are provided to cover each of the sub-regions 5a, 5b, 5c, etc. In the depicted embodiment, each tile of the array of patterns has a rectangular shape. A layer of protectant resin is deposited onto each sub-region. The protectant resin is solidified to form an array of the protective tiles (e.g., 10a, 10b, 10c, etc.) corresponding to the array of sub-regions (e.g., 10a, 10b, 10c, etc.).

In many applications, the first major surface 21 of the substrate 2 may be contaminated thereon with an unacceptable number and size of particles. When coated on the first major surface 21 of the substrate 2, the protectant resin may be flowable and then solidified into a protective tile so as to capture all or a substantial amount of the particles contaminating the sub-regions on the substrate surface. The flowable protectant resin can capture the particles on the surface typically by physically surrounding at least a portion of each of the captured particles. The particles are captured when the coated material solidifies into the layer. Depending on the exact composition of the flowable protectant resin, the solidification of material may be accomplished through drying, cooling, heat curing, radiation curing, polymerization from reactive precursors, or the like. In a roll-to-roll process, it is usually convenient to perform the solidifying while the substrate (e.g., a web) is being conveyed in a continuous motion in the machine direction.

Suitable protectant resin compositions for the substrate 2 may include acrylates such as, for example, radiation curing acrylates, monomeric acrylates, oligomeric acrylates, urethane acrylates, silicone acrylates, fluorinated acrylates, ethoxylated acrylates including, for example, ethoxylated trimethylolpropane triacrylate and preferably six-mole ethoxylated trimethylolpropane triacrylate. In some embodiments, suitable protectant resin compositions for the substrate may also include thermoplastic polymers including polyvinyl alcohol, polyvinyl butyral, polymethyl methacrylate, polystyrene, reactive polymers including, for example, acrylate or vinyl functionalized polystyrene or polymethyl methacrylate, polyolefins including, for example cyclic polyolefin copolymers. In some embodiments, suitable protectant resin compositions for the substrate may further include epoxies including, for example, silicone epoxies, fluorinated epoxies, and radiation curing epoxies. In some embodiments, suitable protectant resin compositions for the substrate may further include polymers formed by ring opening metathesis polymerization.

In some embodiments, suitable protectant resin composition for the substrate may also include various blends of above listed materials additionally including solvents and functional additives such as, for example, surfactants plasticizers, and photoinitiators including diphenyl(2,4,6-trimethylbenzoyl)phosphine oxide.

For example, a suitable protectant resin composition for the substrate may include a blend of multiple commercial grades of polyvinyl alcohol in an aqueous solution, preferably commercial grades of polyvinyl alcohol between 80 and 95% hydrolyzed, preferably with average molecular weight between 9,000 and 124,000, preferably a blend of polyvinyl alcohol with average molecular weight between 31,000-50,000, and polyvinyl alcohol with average molecular weight between 85,000-124,000, and more preferably a blend comprising 50:50 ratio by weight of polyvinyl alcohol with average molecular weight between 31,000-50,000 and polyvinyl alcohol with average molecular weight between 85,000-124,000 in an aqueous solution with concentration in the range from 5-50%, preferably with concentration in the range from 10-25%. For example, a suitable protectant resin composition for the substrate may include a colloidal dispersion of polyurethane in water.

Suitable protectant resin compositions can be unreactive with various adhesion promoters which may be disposed on the first major surface 21 of the substrate 2. Suitable protectant resin compositions can have high enough strength and low enough adhesion to the first major surface 21 of the substrate 2 in order to be peeled from said surface without breakage. Suitable protectant resin compositions can be homogenous and solid at a temperature of at least about 25 degrees Celsius with no constitutive components having melting temperature or glass transition temperature below this threshold so that no residual film is left on the first major surface 21 of the substrate 2 upon peeling said resin from said surface.

In some embodiments, secondary carrier films can be laminated on the protective tiles after the protective tiles are attached to the sub-regions. The lamination of the secondary carrier film can make it easier to remove the protective tiles from the sub-regions. In some embodiments, the secondary carrier films can be applied via a roller. Exemplary secondary carrier films may include polycarbonate, polyethylene terephthalate, polyethylene terephthalate glycol, or polyvinyl alcohol.

At 120, at least one of the protective tiles (e.g., at least one of 10a, 10b, 10c, etc.) is removed from one of the sub-regions (e.g., 5a, 5b, 5c, etc.) to expose the first major surface of the substrate directly beneath. In some embodiments, the protective tile can be removed from the sub-region by peeling the protective tile from the substrate. After removing the protective tile, the sub-regions can be substantially free of ultra-fine particles having a diameter of at least about 0.1 micrometers and larger particles.

At 130, a patterned template 30 having a relief structure 31 is provided to receive a replication medium 20 to in the form of a flowable fluid (e.g., liquid). An optional supporting film 32 can be provided to support the relief structure 31. The relief structure 31 of the patterned template 30 is a structured surface including an arrangement of pattern elements 312 extending away from a base surface thereof and voids 314 formed between the pattern elements 312. The pattern elements 312 can contain microscale and/or nanoscale feature(s) in a regular or random arrangement.

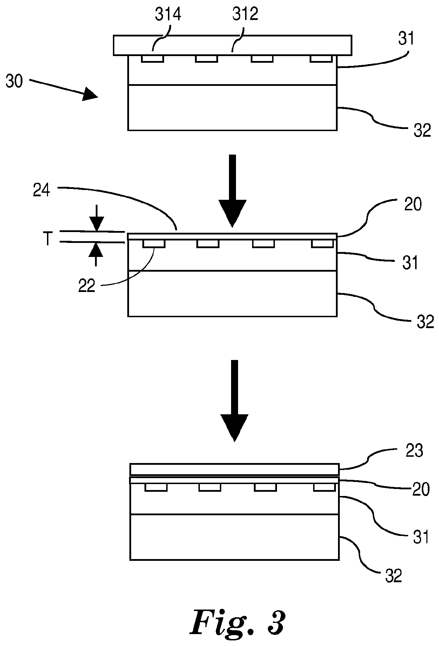

At 135, the replication medium 20 in the form of a flowable fluid (e.g., liquid) is provided onto the relief structure 31 of the patterned template 30, filling voids on the relief structure 31 and conforming to the patterned surface of the relief structure 31. The replication medium 20 is then solidified thereon. FIG. 3 is a cross-sectional schematic diagram of a process of applying the replication medium 20 onto the relief structure 31 of the patterned template 30, according to one embodiment. One preferred replication medium 20 is a curable polymeric resin that is coated as a liquid on the relief structure 31 of the patterned template 30. In some embodiments, the replication medium 30 may include a high molecular weight thermoplastic and a low molecular weight reactive plasticizer to control glass transition temperature of the formulation. The liquid, curable polymeric resin fills is coated onto the relief structure 31 to fill in the voids 314 and cover the pattern elements 312. The coated resin is then solidified to form a solid layer on the relief structure 31 of the patterned template 30. In some embodiments, the curable polymeric resin can be solidified by, for example, a solvent drying process, a reactive partial-curing process, etc. The solidification process results in a polymeric resin that is substantially solid at room temperature. The solid layer of replication medium 20 substantially conforms to the structured surface of the patterned template 30 on a first side 22 of the replication medium 20 and form a planar surface on a second side 24 thereof opposite the first side 22. The solid layer of replication medium 20 has a residual thickness T by excluding the height of the pattern elements 312 of the relief structure. The residual thickness T may be on the order of the relief structure depth or height, in a range, for example, from 10 nm to 1000 micrometers. An optional protective layer 23 can be applied to cover the solid layer of replication medium 20.

In some preferred embodiments, the replication medium 20 includes a reactive thermoplastic polymer, plasticized with a reactive crosslinker. The plasticizer serves to control the glass transition temperature to allow for low temperature lamination. The plasticizer also reacts to further harden the resin before removal of the patterned template. In some embodiments, suitable replication medium compositions may include blends of reactive polymers and reactive monomers, preferably including reactive thermoplastic polymers. Exemplary thermoplastic polymers can include a (meth)acrylate-functional polymer, a vinyl functional polymer, an epoxy-functional polymer, etc. Exemplary plasticizers can include mono-functional (meth)acrylates, multi-functional (meth)acrylates, multi-functional thiols, epoxide monomers, etc.

Suitable replication medium may include resins having a glass transition temperature greater than 25 degrees Celsius when the resins are solidified by drying or curing. Suitable replication medium may include resins having an elastic modulus greater than 300 MPa when the resins are solidified by drying or curing.

In some embodiments, the replication medium may further include radiation curing monomers, polymers, oligomers, solvents, functional additives such as surfactants or others, a combination thereof, etc.

Suitable compositions for the replication medium 20 may further include acrylates including radiation curing acrylates, monomeric acrylates, oligomeric acrylates, urethane acrylates, silicone acrylates, fluorinated acrylates, ethoxylated acrylates. Suitable replication medium compositions may also include thermoplastic polymers including polyvinyl alcohol, polyvinyl butyral, polymethyl methacrylate, polystyrene, reactive polymers including, for example, acrylate or vinyl functionalized polystyrene or polymethyl methacrylate, polyolefins including, for example cyclic polyolefin copolymers. Suitable replication medium compositions may also include epoxies including, for example, silicone epoxies, fluorinated epoxies, and radiation curing epoxies. Suitable replication medium compositions may also include polymers formed by ring opening metathesis polymerization.

Suitable replication medium compositions may also include various blends of above listed materials additionally including solvents and functional additives such as, for example, surfactants plasticizers, and photoinitiators including diphenyl(2,4,6-trimethylbenzoyl)phosphine oxide.

In some embodiments, an adhesion promoter may be included as an additive in the replication medium or may be provided on the planar surface of the replication medium prior to contacting to the substrate 2. The adhesion promoter layer may also be provided on the exposed sub-region of the substrate 2 to promote the adhesion of the replication medium 20 to the sub-region of the substrate. Exemplary silane coupling agents include 3-(trimethoxysilyl)propyl methacrylate. Another exemplary silane coupling agent is (3-trimethoxysilylpropylcarbamoyloxy)ethyl prop-2-enoate, described in Example 7 of U.S. Patent No 9,790,396.

In some embodiments, a patterned template, such as the patterned template 30 in FIG. 1, can be made by applying an overcoat on a master tool, curing the overcoat, and separating the cured overcoat from the master tool to form the patterned template. The overcoat may be a UV-curable resin including at least one of acrylate monomers, acrylate oligomers, UV-curable epoxies, silicone, or silicone acrylate. The relief structure of the patterned template may be a structured surface including an arrangement of pattern elements extending away from a base surface thereof. The pattern elements may have an average lateral dimension in a range, for example, from about 1 nm to 1000 micrometers, and an aspect ratio of height to the lateral dimension in a range, for example, from about 0 to 20.

In some embodiments, the patterned template may include a release layer or release-treated with materials such as, for example, an organosilicon compound (e.g., hexamethyldisiloxane or HMDSO), a fluorinated coating, fluorinated monolayers, silicone coatings, or silicone monolayers. In one example, which is not intended to be limiting, the release layer can be formed through plasma enhanced chemical vapor deposition (PECVD) of hexamethyldisiloxane, which forms a thin surface having a thickness of about 1 nm to about 10 nm, or about 2 nm to about 8 nm. A protective layer can then be applied to the treated relief structure. Application methods may include, for example, overcoating, printing, lamination, or a combination of these processes. Exemplary overcoating methods may include die coating, spray coating, vapor coating, dip coating, spin coating, etc. Exemplary printing methods include digital printing (inkjet, valve jet etc.), flexo-printing, stencil printing etc. Laminated protective layers include single or multilayer films with or without adhesive. Overcoated and printed protective layers include polymer-solvent dispersions, polymer solvent solutions, reactive polymer solutions, ionic networking acrylate, radiation curing monomers, oligomers, thermoplastics, etc. Overcoated and printed protective layers can be set or solidified by a number of methods including radiation curing, thermal curing, drying, etc.

The relief structure of the patterned template can be cleaned by removing a protective layer therefrom before applying a replication medium thereon. In some embodiments, the patterned template 30 can be cleaned by peeling a layer of protectant resin from the relief structure. The relief structure can be substantially free of ultra-fine particles having a diameter of at least about 0.1 micrometers and larger particles after peeling off the protectant resin.

Suitable protectant resin compositions for protecting and cleaning the patterned template 30 may include acrylates including radiation curing acrylates, monomeric acrylates, oligomeric acrylates, urethane acrylates, silicone acrylates, fluorinated acrylates, ethoxylated acrylates including, for example, ethoxylated trimethylolpropane triacrylate and preferably six-mole ethoxylated trimethylolpropane triacrylate. Suitable protectant resin compositions for the template may also include thermoplastic polymers including polyvinyl alcohol, polyvinyl butyral, polymethyl methacrylate, polystyrene, reactive polymers including, for example, acrylate or vinyl functionalized polystyrene or polymethyl methacrylate, polyolefins including, for example cyclic polyolefin copolymers. Suitable protectant resin compositions for the template may also include epoxies including, for example, silicone epoxies, fluorinated epoxies, and radiation curing epoxies. Suitable protectant resin compositions for the substrate may also include polymers formed by ring opening metathesis polymerization.

Suitable protectant resin composition for the template may also include various blends of above listed materials additionally including solvents and functional additives such as, for example, surfactants plasticizers, and photoinitiators including diphenyl(2,4,6-trimethylbenzoyl)phosphine oxide.

For example, a suitable protectant resin composition for the template may include a blend of multiple commercial grades of polyvinyl alcohol in an aqueous solution, preferably commercial grades of polyvinyl alcohol between 80 and 95% hydrolyzed, preferably with average molecular weight between 9,000 and 124,000, preferably a blend of polyvinyl alcohol with average molecular weight between 31,000-50,000, polyvinyl alcohol with average molecular weight between 85,000-124,000, and glycerol, and more preferably a blend comprising 45:45:10 ratio by weight of polyvinyl alcohol with average molecular weight between 31,000-50,000, polyvinyl alcohol with average molecular weight between 85,000-124,000, and glycerol in an aqueous solution with concentration in the range from 5-50%, preferably with concentration in the range from 10-25%. For example, a suitable protectant resin composition for the template may include a colloidal dispersion of polyurethane in water.

The relief structure 31 of the patterned template 30 can be cleaned by any suitable cleaning methods. Typical cleaning methods may include encapsulant stripping, solvent rinse, sonication, CO₂ snow cleaning etc. Solvent rinsing includes sequential rinses with solvents such as isopropanol, acetone, de-ionized water etc. Encapsulant stripping describes the removal of overcoated, printed, or adhesive protective layers where particles are encapsulated by or adhered to the protective lay in the application process and stripped from the patterned templates when the protective layer is removed. Removal of a protective layer may be done with the aid of static neutralization including static string, nuclear type static bars, active static bars etc.

Referring again to FIG. 2, at 140, the patterned template 30 along with the solid layer of replication medium 20 is provided to contact one sub-region of the substrate 2. The planar surface 24 of the solid layer of the replication medium 20 is in direct contact to the sub-region of the substrate 2. The lamination of the patterned template and the substrate may be achieved by roller lamination, by manual lamination, by substrate-wide precision roll lamination, by deformable (membrane or compliant) lamination device, etc.

Patterned templates can be converted by removing at least some non-structured margins thereof before transferring to a flat or curved substrate. Converting methods may include, for example, press punch converting, rotary die cutting, laser cutting, scissor cutting, etc. Converting may include lamination of a carrier layer to allow for roll to roll handling of patterned templates after converting. Patterned templates may be kiss-cut to a carrier layer and left in a continuous roll or sheeted and packaged in-line as individual parts.

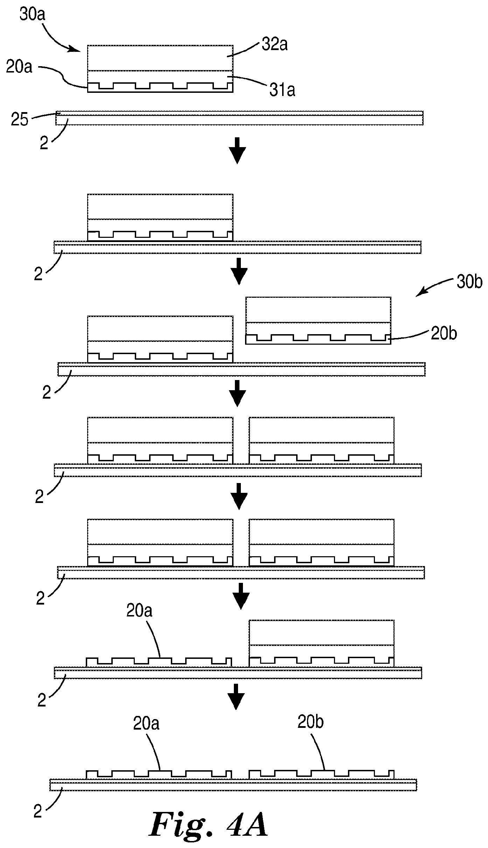

In some embodiments, the coated patterned templates can be transferred for tiling a flat substrate through a serial or parallel approach (e.g., as illustrated in the embodiments of FIGS. 4A-B). The substrate can optionally be cleaned before the transferring. Cleaning can be accomplished by the use of solvent, ultra-sonic baths, detergents, encapsulant strippable coatings, plasma, etc. The replication medium can be brought in contact with the flat substrate. The coated patterned templates can be secured to the substrate via various mechanisms including, for example, thermal exposure, thermal lamination, thermal curing, UV exposure or curing, an additional adhesive layer (optical clear adhesive or OCA, etc.), coupling agents, surface treatments, degrading agents, etc. The patterned templates can also be partially transferred to the substrate by masking off surrounding regions on the substrate. The patterned surface structure of the replication medium can then be exposed. The exposure can happen through a peeling and/or washing process depending on the material configuration of the coated patterned template. The resulting flat substrate with attached tiles can be referred to as a patterned structured surface substrate.

In some embodiments, the coated patterned templates can be transferred for tiling a curved substrate (e.g., a cylindrical sleeve) through a serial or parallel approach (e.g., as illustrated in the embodiments of FIGS. 4A-B). The replication media on the patterned templates can be brought in contact with the curved substrate through a rolling line-contact. A stage can be provided to move in coordination with the rotation of the curved substrate. The coated patterned templates can be held down to the stage with a vacuum chuck. To transfer the coated patterned templates from the stage to the curved substrate, the adhesion force between the replication material and the substrate can be great enough to overcome the force of the vacuum chuck. Alternatively, the vacuum chuck can contain phases that can coordinate the level of vacuum with the contact line between the replication media and the substrate. The stage configuration and/or the material stack can include other compliant and/or release layers to allow for better transfer of the coated patterned templates from the stage to the curved substrate.

Optionally, heat can be applied to the coated replication medium 20 such that the solid layer of the replication medium 20 is sufficiently flowable to make conformal contact with the substrate. The composition of the replication medium can be designed to lower the processing temperatures so that thermal expansion mismatch between the replication medium, the substrate, and the patterned template can be minimized.

Further, optionally, the replication medium can be hardened through curing. For example, curing can be carried out by exposing the replication medium 20 to actinic radiation to crosslink the polymer. For example, in the embodiments depicted in FIGS. 1 and 2, at 150, the replication medium 20 is cured to form a hardened layer 20' before removing the patterned template 30 from the sub-region of the substrate. One or more energy sources can be positioned such that emitted energy can cure the replication medium 20 while the resin 20 is in contact with both the relief structure of the patterned template 30 and the sub-region of the substrate. The energy source may be capable of emitting energy, e.g., UV radiation, e-beam radiation, or heat. When the energy source emits radiation, the recipient substrate and/or the patterned template can be substantially transparent to the radiation to allow curing of the replication medium 20.

At 160, after the replication medium 20 is hardened, the patterned template 30 is removed from the sub-region to expose the formed replication pattern on the hardened or toughened replication medium 20'. In some embodiments, the patterned template can be left on and act as a protectant layer for the structure on some sub-regions while the other sub-regions are being laminated sequentially.

At 170, a protective layer 40 is provided to cover the formed replication pattern on the hardened or toughened replication medium 20' within the sub-region. The protective layer 40 may be a washable or strippable protective layer. The protective layer 40 may include a protectant resin such as, for example, polymer-solvent dispersions, polymer solvent solutions, reactive polymer solutions, ionic networking acrylate, radiation curing monomers, oligomers, thermoplastics, etc. It is to be understood that in some embodiments, the preferred protection may be provided by leaving the patterned template in place rather than doing an additional coating step for protection.

Suitable protectant resin composition 40 for protecting and cleaning the replication pattern 20' may include acrylates including radiation curing acrylates, monomeric acrylates, oligomeric acrylates, urethane acrylates, silicone acrylates, fluorinated acrylates, ethoxylated acrylates including, for example, ethoxylated trimethylolpropane triacrylate and preferably six-mole ethoxylated trimethylolpropane triacrylate. Suitable protectant resin compositions for the replication pattern may also include thermoplastic polymers including polyvinyl alcohol, polyvinyl butyral, polymethyl methacrylate, polystyrene, reactive polymers including, for example, acrylate or vinyl functionalized polystyrene or polymethyl methacrylate, polyolefins including, for example cyclic polyolefin copolymers. Suitable protectant resin compositions for the replication pattern may also include epoxies including, for example, silicone epoxies, fluorinated epoxies, and radiation curing epoxies. Suitable protectant resin compositions for the replication pattern may also include polymers formed by ring opening metathesis polymerization.

Suitable protectant resin composition for the replication pattern may also include various blends of above listed materials additionally including solvents and functional additives such as, for example, surfactants plasticizers, and photoinitiators including diphenyl(2,4,6-trimethylbenzoyl)phosphine oxide.

For example, a suitable protectant resin composition for the replication pattern may include a blend of multiple commercial grades of polyvinyl alcohol in an aqueous solution, preferably commercial grades of polyvinyl alcohol between 80 and 95% hydrolyzed, preferably with average molecular weight between 9,000 and 124,000, preferably a blend of polyvinyl alcohol with average molecular weight between 31,000-50,000, polyvinyl alcohol with average molecular weight between 85,000-124,000, and glycerol, and more preferably a blend comprising 45:45: 10 ratio by weight of polyvinyl alcohol with average molecular weight between 31,000-50,000, polyvinyl alcohol with average molecular weight between 85,000-124,000, and glycerol in an aqueous solution with concentration in the range from 5-50%, preferably with concentration in the range from 10-25%. For example, a suitable protectant resin composition for the replication pattern may include a colloidal dispersion of polyurethane in water.

At 180, the steps from 120 to 170 are repeated for each of the rest of the sub-regions to form a replication pattern within each sub-region. In some embodiments, some steps can be completed in the order listed for each subregion in order to benefit from the process design (e.g., to complete steps 120 through 170 for subregion 1, then complete steps 120 through 170 for subregion 2; don't do step 120 for subregions 1 and 2, then step 130 for subregions 1 and 2, etc.). In some embodiments, the steps can be repeated by using one or more patterned templates (e.g., from one up to the number of subregions). The steps can be repeated to pattern a large area with fine features as compared to conventional direct patterning methods. The protective layers used herein can eliminate opportunities for particulate contamination and damage in the step and repeat process.

It is to be understood that the steps in FIG. 1 or 2 can be combined and/or repeated in any suitable order to form an array of patterns on a substrate. FIG. 4A is a schematic diagram of a serial process for forming an array of patterns on a substrate 2, according to one embodiment. An optional adhesion promoter layer 25 is provided on the exposed sub-region of the substrate 2 to promote the adhesion of the replication medium 20a or 20b to the sub-region of the substrate. First and second patterned templates 30a and 30b with the respective solid layers 20a and 20b of replication medium are provided to apply sequentially onto a first sub-region and a second sub-region of the tiling region on the major surface of the substrate, respectively. The first patterned templates 30a, including a relief structure 31a supported by a film 32a and coated with the solid layer 20a of replication medium, is positioned with the solid layer 20a of replication medium facing the first sub-region of the substrate, and then contacts its planar surface of the solid layer 20a to the first sub-region of the substrate. Then, the second patterned templates 30b, including a relief structure 31b supported by a film 32b and coated with the solid layer 20b of replication medium, is positioned with the solid layer 20b of replication medium facing the second sub-region of the substrate, and then contacts its planar surface of the solid layer 20b to the second sub-region of the substrate. While maintaining the contact of the replication media of the first and second patterned templates with the first and second sub-regions of the substrate, heat can be applied to be above the melting temperature or glass transition temperature of the replication medium such that the replication medium are sufficiently flowable to make conformal contact with the respective sub-regions of the substrate. Then, heat or actinic radiation can be applied to at least partially cure, harden, or roughen the replication media before removing the patterned templates from the respective sub-regions of the substrate independently or in parallel order. It is to be understood that the heating or curing can be applied to the replication media for different sub-regions independently or in parallel order.

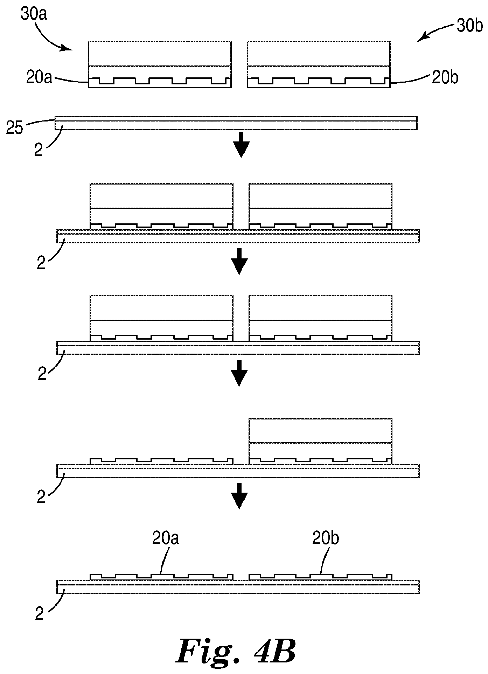

FIG. 4B is a schematic diagram of a simultaneous process for forming an array of patterns on the substrate 2, according to another embodiment. An optional adhesion promoter layer 25 is provided on the exposed sub-region of the substrate 2 to promote the adhesion of the replication medium 20a or 20b to the sub-region of the substrate. The first and second patterned templates 30a and 30b with the respective solid layers 20a and 20b of replication medium are provided to apply at the same time onto the first sub-region and the second sub-region of the tiling region on the major surface of the substrate, respectively. The first and second patterned templates 30a and 30b are positioned with the respective solid layers 20a and 20b of replication medium facing the first and second sub-regions of the substrate, and then contact their planar surfaces of the solid layers 20a and 20b to the first and second sub-regions of the substrate, respectively. While maintaining the contact of the replication media of the first and second patterned templates with the first and second sub-regions of the substrate, heat can be applied such that the replication media 20a and 20b can be above the melting temperature or glass transition temperature and are sufficiently flowable to make conformal contact with the respective sub-regions of the substrate. Then, heat or actinic radiation can be applied to at least partially cure, harden, or roughen the replication media before removing the patterned templates from the respective sub-regions of the substrate independently or in parallel order. It is to be understood that the patterned templates on different sub-regions can be removed independently or in parallel order.

Referring again to FIG. 1 or 2, at 190 (and 195 in FIG. 1), the protective layers 40 can be selectively removed from the respective sub-regions of the substrate to reveal the underneath hardened or toughened replication medium 20'. The revealed replication patterns on the hardened or toughened replication medium 20' can be used for various applications. The replication pattern can contain microscale and/or nanoscale feature(s) in a regular or random arrangement. After removing the protective layers 40, the replication patterns on the cured resin 20' can be substantially free of ultra-fine particles having a diameter of at least about 0.1 micrometers and larger particles.

Articles and methods described herein have various applications. For example, it can be used to develop a process technology for making large-area-coverage nano-structured tools for pattern replication. Replication tools can be made by using the patterned surface structure on the sub-regions of a substrate (e.g., the replication patterns of the hardened or toughened replication medium 20' in FIGS. 1-3 and 20a-b in FIGS. 4A-B). In some embodiments, the patterned surface structure can be metalized with a seed layer followed by electroplating to fill voids in the patterned surface structure to form a metallic replica. In some embodiments, a polymer replication material can be applied to the patterned surface structure of the substrate. The polymer replication material is then set and removed from the substrate to form a replication tool. In some embodiments, a replication tool can be formed by etching into the substrate using the patterned surface structure as a mask.

Structured patterns can be made on cylindrical tools with length scales on the order of microscale and nanoscale. This provides a robust way of producing cylindrical tools with smaller features (e.g., nanoscale) and/or with patterns that are not conducive to traditional micro-structured tooling manufacturing routes such as diamond turning machines (DTMs).

Exemplary embodiments of the present disclosure provide a substantially solid replication medium at room temperature which is formed on a patterned template. The processes described herein can ease handling and storage during intermediate processing steps such as, for example, while coating or transferring replication medium on other patterned templates for other subregions on the same substrate. Embodiments described herein are advantageous over conventional imprint lithography techniques which use a liquid replication medium where particles can become embed into the replication medium during storage and the coating can continue to flow during handling. In embodiments of the present disclosure, the planar surface of the solid replication medium can be inspected for contamination prior to transferring to the substrate which is advantageous for deducing overall defectivity on the patterned surface structure on the substrate as the defectivity in each subregion can be monitored and regulated during the process. Embodiments described herein are advantageous compared to conventional imprint techniques which coat a substrate with replication medium and the defectivity of one subregion can be substantially higher than the others and render the pattered substrate unusable for the desired applications.

Embodiments of the present disclosure further provide a curable polymer resin replication medium having its planar surface in contact to a sub-region of a substrate. The curable polymer resin replication medium has a reduced temperature required to allow the material to become substantially flowable in order to conform the planar surface to the substate. Embodiments described herein are advantageous over conventional imprint lithography as it reduces the process temperature and therefore reduces the potential for distortion of the relief structures of patterned templates due to mismatch of the thermal expansion coefficients of the patterned templates, replication medium, and substrate.

The operation of the present disclosure will be further described with regard to the following detailed examples. These examples are offered to further illustrate the various specific and preferred embodiments and techniques. It should be understood, however, that many variations and modifications may be made while remaining within the scope of the present disclosure.

### EXAMPLES

These Examples are merely for illustrative purposes and are not meant to be overly limiting on the scope of the appended claims. Notwithstanding that the numerical ranges and parameters setting forth the broad scope of the present disclosure are approximations, the numerical values set forth in the specific examples are reported as precisely as possible. Any numerical value, however, inherently contains certain errors necessarily resulting from the standard deviation found in their respective testing measurements. At the very least, each numerical parameter should at least be construed in light of the number of reported significant digits and by applying ordinary rounding techniques.

### Summary of Materials

Unless otherwise noted, all parts, percentages, ratios, etc. in the Examples and the rest of the specification are by weight. Table 1 provides abbreviations and a source for all materials used in the Examples below:

**Table 1**

| **Abbreviation** | **Description** | **Source** |
|---|---|---|
| IRGACURE TPO | Diphenyl(2,4,6-trimethylbenzoyl)phosphine oxide a photo initiator obtained under the trade designation IRGACURE TPO | BASF, Florham Park, NJ |
| DOWANOL PM | 1-Methoxy-2-Propanol | MiliporeSigma, St. Louis, Missouri |
| HMDSO | Hexamethyldisiloxane | MiliporeSigma, St. Louis, Missouri |
| | 2-(3-trimethoxysilylpropylcarbamoyloxy)ethyl prop-2-enoate; assembled as described in Example 7 of U.S. Patent No 9,790,396 | 3M Company, St. Paul, Minnesota |
| PHOTOMER 6210 | Urethane acrylate oligomer obtained under the trade designation PHOTOMER 6210 | IGM Resins, Charlotte, NC |
| SR238 | 1,6-Hexandiol diacrylate obtained under the trade designation SR238 | Sartomer, Exton, Pennsylvania |
| SR351 | Trimethylolpropane triacrylate obtained under the trade designation SR351 | Sartomer, Exton, Pennsylvania |
| Lumicryl 2382 | UV/EB-curable acrylic macromer supplied in t-butyl acetate obtained under the trade name Lumicryl 2382 | Estron Chemical, Calvert City, KY |
| EB350 | Silicone diacrylate obtained under the trade designation Ebecryl 350. | Allnex USA Inc., Alpharetta, Georgia |
| Acetone | Acetone | MiliporeSigma, St. Louis, Missouri |
| IPA | Isopropyl alcohol | MiliporeSigma, St. Louis, Missouri |
| MEK | Methyl Ethyl Ketone | MiliporeSigma, St. Louis, Missouri |

### Examples

### Example 1: Single transfer

Patterned template used in this example included a silicon containing release layer assembled according to the "method for release treatment" described in WO2020/095258 over a 5-micron thick structured layer composed of PHOTOMER 6210, SR238, SR351, and IRGACUR TPO in weight ratios of 60/20/20/0.5 on a polycarbonate backing film 4 thousandths of an inch in thickness (0.1 mm). The pattern of the patterned templates was an array of posts 150 nm in diameter and 450 nm in height. The pattern area size was 43 mm by 7mm.

The substrate used in this example was Fischer 2 by 3 inch (5 cm by 7.6 cm) borosilicate microscope slide prepared by rinsing the with acetone and IPA wiping with a Vectra TX1010 clean room wipe. The substrate was treated with adhesion promoter. A 0.5 wt% solution of 2-(3-trimethoxysilylpropylcarbamoyloxy)ethyl prop-2-enoate; 3M Company (St. Paul), assembled as described in Example 7 of U.S. Patent No 9,790,396 in MEK was spin coated onto the substrate. The coating conditions were 1000 rpm for 60 seconds. The coated glass was exposed to a temperature of 140 degrees Celsius for 15 minutes before being cooled to room temperature.

The curable polymeric resin was prepared by combining and mixing DOWANOL PM, Lumicryl 2382, EB350, and TPO, in weight ratios of 796/182/21/1. The curable polymeric resin was spin coated onto the relief structured surface of the patterned template. The spin coating conditions were 500 rpm for 5 seconds and 1000 rpm for 30 seconds after statically applying a sufficient volume of curable polymeric resin to cover the relief structured region of the patterned template. The coated template was exposed to 60 degrees Celsius for 5 minutes to drive off any remaining solvent. The residual material was sufficiently solid at room temperature.

The planer surface of the curable polymeric replication medium was laminated to a treated glass with a hot roll laminator at the lowest speed setting at a temperature of 145°F (62.8°C). The nip was engaged with 60 psi (0.41 MPa). A 385 nm LED UV curing lamp was used to cure the replication medium. The sample was cured through the patterned template at 40V, 8A input for 90 seconds. The patterned template was subsequently peeled. By this process, the replication medium was transferred to the glass and the relief structure was exposed.

### Example 2: 2x2 tiled array parallel transfer

The substrate used in this example was Corning EAGLE XG 200.0x200.0x0.70 mm glass from Precision Glass & Optics, Santa Ana, CA prepared cleaning with a spin coater and solvent. The spin coater settings were an acetone dynamic dispense at 350 rpm for 10 seconds, IPA dynamic dispense at 350 rpm for 10 seconds, and drying at 1000 rpm for 15 seconds. The substrate was treated with adhesion promoter. A 0.5 wt% solution of 2-(3-trimethoxysilylpropylcarbamoyloxy)ethyl prop-2-enoate; 3M Company (St. Paul), assembled as described in Example 7 of U.S. Patent No 9,790,396 in MEK was spin coated onto the substrate. The coating conditions were 500 rpm for 5 seconds and 1000 rpm for 30 seconds. The coated glass was exposed to a temperature of 140 degrees Celsius for 60 minutes before being cooled to room temperature. The patterned template was prepared as in Example 1, except a 3 mil (0.08 mm)primed polyethylene terephthalate film was used as the backing film. The release treatment was preformed as in Example 1.

The curable polymeric resin was prepared by combining and mixing DOWANOL PM, Lumicryl 2382, EB350, and TPO, in weight ratios of 776/193/22/2. The curable polymeric resin was spin coated onto the relief structured surface of the patterned template. The spin coating conditions were 500 rpm for 5 seconds and 1000 rpm for 60 seconds and the coated template was let dry for 2 minutes at room temperature. The replication medium solution was filtered to 0.2um. A protective layer of Hitachi Chemical Co. LD-K1010-75 (Lot#3926498408) was laminated with a hand roller to the planer surface of the replication medium. The coating was performed on four patterned templates.

The protective layer was removed from the planer surface of the curable polymeric replication medium on the first, second, third, and fourth patterned template. The planer surfaces of the replication medium on the first, second, third, and four patterned templates were simultaneously vacuum laminated (<26.7 Pa) to the first, second, third, and four subregions of the treated glass substrate with 60 psi (0.41 MPa) being applied to the surface of the patterned templates opposite the replication medium coating while being heated at 50 degrees Celsius for 45 minutes. The pressure was reduced from 60 psi (0.41 MPa) to atmospheric pressure (0.10 MPa). A 385 nm LED UV curing lamp was used to cure the replication medium. The sample was cured through the patterned template at 40V, 8A input for 5 minutes. The patterned templates were subsequently peeled. By this process, the replication medium was transferred to the glass and the relief structure was exposed in two subregions of the substrate.

While the specification has described in detail certain exemplary embodiments, it will be appreciated that those skilled in the art, upon attaining an understanding of the foregoing, may readily conceive of alterations to, variations of, and equivalents to these embodiments. Accordingly, it should be understood that the invention is defined only by the appended claims.

## Claims

1. A method of making a patterned surface structure on a substrate (2) comprising: providing one or more patterned templates (30) each including a relief structure (31);
coating the relief structure of each patterned template with a replication medium (20) in the form of a liquid;
solidifying the replication medium to replicate a pattern of the relief structure on a first side (22) of the replication medium and form a substantially planar surface on a second side (24) thereof opposite the first side;
transferring the one or more patterned templates with the respective replication media to an array of sub-regions (5a, 5b, 5c) of a tiling region on a major surface (21) of a substrate, the substantially planar surface of each replication medium being in contact to the respective sub-regions of the substrate; and
removing the one or more patterned templates from the substrate to form a patterned surface structure on the substrate;
wherein the one or more patterned templates comprises first (30a) and second (30b) patterned templates, and transferring the one or more patterned templates further comprises transferring the first and second templates either
(i) sequentially onto a first sub-region and a second sub-region of the tiling region on the major surface of the substrate, respectively, or
(ii) at the same time onto a first sub-region and a second sub-region of the tiling region on the major surface of the substrate, respectively.

2. The method of claim 1, further comprising hardening or toughening the replication media through curing before removing the one or more patterned templates.

3. The method of claim 1 or claim 2, further comprising heating the replication media to make a conformal contact with the sub-regions of the substrate.

4. The method of any one of claims 1-3, wherein transferring the one or more patterned templates comprises transferring the first and second patterned templates sequentially onto a first sub-region and a second sub-region of the tiling region on the major surface of the substrate, respectively.

5. The method of any one of claims 1-4, wherein transferring the one or more patterned templates comprises transferring the first and second patterned templates at the same time onto a first sub-region and a second sub-region of the tiling region on the major surface of the substrate, respectively.

6. The method of any one of claims 1-5, further comprising generating a tool using the patterned surface structure of the substrate.

7. The method of claim 6, wherein generating the tool further comprises metalizing the patterned surface structure with a seed layer followed by electroplating to fill voids in the patterned surface structure to form a metallic replica.

8. The method of claim 6, wherein generating the tool comprises applying a polymer replication material to the patterned surface structure of the substrate, and set and remove the polymer replication material from the substrate.

9. The method of claim 6, wherein generating the tool comprises etching into the substrate using the patterned surface structure as a mask.

10. The method of any one of claims 1-9, wherein the relief structure of the one or more patterned templates comprises an arrangement of pattern elements extending away from a base surface thereof, the pattern elements having an average lateral dimension in a range from 1 nm to 1000 micrometers, and an aspect ratio of height to the lateral dimension in a range from 0 to 20.

11. The method of any one of claims 1-10, wherein the substrate comprises at least one of a flexible polymer, a rigid polymer, glass, quartz, a silicon wafer, or a polished metal.

12. The method of any one of claims 1-11, wherein the major surface of the substrate comprises an adhesion promoter layer.

13. The method of any one of claims 1-12, wherein the relief structure of each patterned template comprises a release layer.

14. The method of any one of claims 1-13, wherein at least one of the one or more patterned templates includes a flexible film.

15. The method of any one of claims 1-14, wherein at least one of the one or more patterned templates includes a rigid plate.

## Patentansprüche

1. Ein Verfahren zum Fertigen einer gemusterten Oberflächenstruktur auf einem Substrat (2), aufweisend:
Bereitstellen einer oder mehrerer gemusterter Schablonen (30), die jeweils eine Reliefstruktur (31) einschließen; Beschichten der Reliefstruktur von jeder strukturierten Schablone mit einem Replikationsmedium (20) in Form einer Flüssigkeit;
Erstarren des Replikationsmediums, um ein Muster der Reliefstruktur auf einer ersten Seite (22) des Replikationsmediums zu replizieren und eine im Wesentlichen ebene Oberfläche auf einer zweiten Seite (24) davon gegenüber der ersten Seite zu bilden: Übertragen der einen oder der mehreren strukturierten Schablonen mit den jeweiligen Replikationsmedien zu einem Array von Teilregionen (5a, 5b, 5c) einer Kachelregion auf einer Hauptoberfläche (21) eines Substrats, wobei die im Wesentlichen ebene Oberfläche jedes Replikationsmediums in Kontakt mit den jeweiligen Teilregionen des Substrats steht; und
Entfernen der einen oder der mehreren gemusterten Schablonen von dem Substrat, um eine gemusterte Oberflächenstruktur auf dem Substrat zu bilden;
wobei die eine oder die mehreren gemusterten Schablonen eine erste (30a) und eine zweite (30b) gemusterte Schablone aufweisen, und das Übertragen der einen oder der mehreren gemusterten Schablonen ferner das Übertragen der ersten und der zweiten Schablone aufweist, entweder
(i) sequenziell auf eine erste Teilregion bzw. eine zweite Teilregion der Kachelregion auf der Hauptoberfläche des Substrats, oder
(ii) gleichzeitig auf eine erste Teilregion bzw. eine zweite Teilregion der Kachelregion auf der Hauptoberfläche des Substrats.

2. Das Verfahren nach Anspruch 1, ferner aufweisend ein Härten oder Zähigmachen des Replikationsmediums durch Aushärten vor dem Entfernen der einen oder der mehreren gemusterten Schablonen.

3. Das Verfahren nach Anspruch 1 oder 2, ferner aufweisend ein Erwärmen des Replikationsmediums, um einen konformen Kontakt mit den Teilregionen des Substrats herzustellen.

4. Das Verfahren nach einem der Ansprüche 1 bis 3, wobei das Übertragen der einen oder der mehreren gemusterten Schablonen das sequenzielle Übertragen der ersten und der zweiten gemusterten Schablone auf eine erste Teilregion bzw. eine zweite Teilregion der Kachelregion auf der Hauptoberfläche des Substrats aufweist.

5. Das Verfahren nach einem der Ansprüche 1 bis 4, wobei das Übertragen der einen oder der mehreren gemusterten Schablonen das Übertragen der ersten und der zweiten gemusterten Schablone zu der gleichen Zeit auf eine erste Teilregion bzw. eine zweite Teilregion der Kachelregion auf der Hauptoberfläche des Substrats aufweist.

6. Das Verfahren nach einem der Ansprüche 1 bis 5, ferner aufweisend ein Erzeugen eines Werkzeugs unter Verwendung der gemusterten Oberflächenstruktur des Substrats.

7. Das Verfahren nach Anspruch 6, wobei das Erzeugen des Werkzeugs ferner ein Metallisieren der gemusterten Oberflächenstruktur mit einer Keimschicht gefolgt von Galvanisieren, um Hohlräumen in der gemusterten Oberflächenstruktur zu füllen, um eine metallische Nachbildung zu bilden, aufweist.

8. Das Verfahren nach Anspruch 6, wobei das Erzeugen des Werkzeugs ein Aufbringen eines Polymer-Replikationsmaterials auf die gemusterte Oberflächenstruktur des Substrats und ein Abbinden und Entfernen des Polymer-Replikationsmaterials von dem Substrat aufweist.

9. Das Verfahren nach Anspruch 6, wobei das Erzeugen des Werkzeugs ein Ätzen in das Substrat unter Verwendung der gemusterten Oberflächenstruktur als Maske aufweist.

10. Das Verfahren nach einem der Ansprüche 1 bis 9, wobei die Reliefstruktur der einen oder der mehreren gemusterten Schablonen eine Anordnung von Musterelementen aufweist, die sich von einer Basisoberfläche davon weg erstrecken, wobei die Musterelemente eine durchschnittliche laterale Abmessung in einem Bereich von etwa 1 nm bis 1000 Mikrometer und ein Seitenverhältnis von Höhe zu lateraler Abmessung in einem Bereich von etwa 0 bis 20 aufweisen.

11. Das Verfahren nach einem der Ansprüche 1 bis 10, wobei das Substrat mindestens eines von einem flexiblen Polymer, einem starren Polymer, Glas, Quarz, einem Siliciumwafer oder einem polierten Metall aufweist.

12. Das Verfahren nach einem der Ansprüche 1 bis 11, wobei die Hauptoberfläche des Substrats eine Haftvermittlerschicht aufweist.

13. Das Verfahren nach einem der Ansprüche 1 bis 12, wobei die Reliefstruktur von jeder gemusterten Schablone eine Trennschicht aufweist.

14. Das Verfahren nach einem der Ansprüche 1 bis 13, wobei mindestens eine der einen oder der mehreren gemusterten Schablonen eine flexible Folie aufweist.

15. Das Verfahren nach einem der Ansprüche 1 bis 14, wobei mindestens eine der einen oder der mehreren gemusterten Schablonen eine starre Platte einschließt.

## Revendications

1. Procédé de réalisation d'une structure de surface à motifs sur un substrat (2), comprenant :
la fourniture d'un ou plusieurs gabarits à motifs (30) comportant chacun une structure en relief (31) ; le revêtement de la structure en relief de chaque gabarit à motifs avec un support de réplication (20) sous la forme d'un liquide ;
la solidification du support de réplication pour répliquer un motif de la structure en relief sur un premier côté (22) du support de réplication et former une surface sensiblement plane sur un second côté (24) de celui-ci opposé au premier côté : le transfert du ou des gabarits à motifs avec les supports de réplication respectifs vers un réseau de sous-régions (5a, 5b, 5c) d'une région de pavage sur une surface principale (21) d'un substrat, la surface sensiblement plane de chaque support de réplication étant en contact avec les sous-régions respectives du substrat ; et
le retrait du ou des gabarits à motifs du substrat pour former une structure de surface à motifs sur le substrat ;
dans lequel le ou les gabarits à motifs comprennent des premier (30a) et second (30b) gabarits à motifs, et le transfert du ou des gabarits à motifs comprend en outre le transfert des premier et second gabarits soit
(i) séquentiellement sur une première sous-région et une seconde sous-région de la région de pavage sur la surface principale du substrat, respectivement, soit
(ii) simultanément sur une première sous-région et une seconde sous-région de la région de pavage sur la surface principale du substrat, respectivement.

2. Procédé selon la revendication 1, comprenant en outre l'augmentation de la dureté ou l'augmentation de la ténacité des supports de réplication par durcissement avant le retrait du ou des gabarits à motifs.

3. Procédé selon la revendication 1 ou la revendication 2, comprenant en outre le chauffage des supports de réplication pour établir un contact conforme avec les sous-régions du substrat.

4. Procédé selon l'une quelconque des revendications 1 à 3, dans lequel le transfert du ou des gabarits à motifs comprend le transfert séquentiel des premier et second gabarits à motifs sur une première sous-région et une seconde sous-région de la région de pavage sur la surface principale du substrat, respectivement.

5. Procédé selon l'une quelconque des revendications 1 à 4, dans lequel le transfert du ou des gabarits à motifs comprend le transfert simultané des premier et second gabarits à motifs sur une première sous-région et une seconde sous-région de la région de pavage sur la surface principale du substrat, respectivement.

6. Procédé selon l'une quelconque des revendications 1 à 5, comprenant en outre la génération d'un outil à l'aide de la structure de surface à motifs du substrat.

7. Procédé selon la revendication 6, dans lequel la génération de l'outil comprend en outre la métallisation de la structure de surface à motifs avec une couche de germination suivie d'une galvanoplastie pour remplir des vides dans la structure de surface à motifs afin de former une réplique métallique.

8. Procédé selon la revendication 6, dans lequel la génération de l'outil comprend l'application d'un matériau de réplication polymère sur la structure de surface à motifs du substrat, et la prise et le retrait du matériau de réplication polymère du substrat.

9. Procédé selon la revendication 6, dans lequel la génération de l'outil comprend une gravure dans le substrat à l'aide de la structure de surface à motifs en guise de masque.

10. Procédé selon l'une quelconque des revendications 1 à 9, dans lequel la structure en relief du ou des gabarits à motifs comprend un agencement d'éléments de motif s'étendant à l'opposé d'une surface de base de celle-ci, les éléments de motif ayant une dimension latérale moyenne dans une plage allant de 1 nm à 1000 micromètres, et un rapport d'aspect de la hauteur à la dimension latérale dans une plage allant de 0 à 20.

11. Procédé selon l'une quelconque des revendications 1 à 10, dans lequel le substrat comprend au moins l'un parmi un polymère souple, un polymère rigide, du verre, du quartz, une plaquette de silicium ou un métal poli.

12. Procédé selon l'une quelconque des revendications 1 à 11, dans lequel la surface principale du substrat comprend une couche promotrice d'adhérence.

13. Procédé selon l'une quelconque des revendications 1 à 12, dans lequel la structure en relief de chaque gabarit à motifs comprend une couche anti-adhésive.

14. Procédé selon l'une quelconque des revendications 1 à 13, dans lequel au moins l'un parmi le ou les gabarits à motifs comporte un film souple.

15. Procédé selon l'une quelconque des revendications 1 à 14, dans lequel au moins l'un parmi le ou les gabarits à motifs comporte une plaque rigide.
